# EUROPEAN PATENT APPLICATION

(11) **EP 1 853 100 A1**
(43) Date of publication of application: **07.11.2007**
(21) Application number: 07002453.4
(22) Date of filing: 05.02.2007
(51) Int. Cl.: H05K 7/20, G06F 1/20

(54) **Cooling system for consumer electronics device**

(30) Priority: 01.05.2006 US 796758 P
(71) Applicant: Nyko Technologies, Inc., Los Angeles CA 90025 (US)
(72) Inventor: Naghi, Herschel, California 90210 (US); Navid, Amir, California 91043 (US)
(74) Representative: Kensett, John Hinton

(57) **Abstract**

A cooling system has one or more fans disposed within a housing adapted to attach to a consumer electronics device. The cooling system can also include a switch, a male connector and a female connector adapted to interface with the consumer electronics device and a power supply of the consumer electronics device. The cooling system may have a pass-through design, in which it receives power from the power supply of the consumer electronics device, taps into the power for its own operation, and passes the power onto the consumer electronics device, and/or it receives power from the consumer electronics device, taps into the power, and passes the power on to another device. The cooling system can also include one or more battery chargers attached to the housing for charging batteries related to the consumer electronics device.

## Description

The present invention relates to cooling systems, and more particularly to a cooling system for a consumer electronics device.

Advances in technology have led to the development of powerful integrated circuits that are often packed into small form factors. As such, consumer electronics devices can have heat dissipation problems. These heat dissipation problems can lead to an overload condition and/or failure of the device. Manufacturers of devices in fast paced markets like the video game industry may not be aware of or have the time to solve these problems before a product goes to market. Therefore, it is desirable to provide an apparatus for cooling a consumer electronics device with heat dissipation problems.

In exemplary embodiments of the present invention, a cooling system including at least one fan, a housing, a switch, a control circuit, and two connectors, is provided. The housing may contain the fans. The switch may be mounted in the housing. The connectors may be made a part of the housing. The cooling system may be adapted to interface with a video game console. When the cooling system is electrically connected with the video game console and video game console power supply, power can be provided to the switch. A user can enable the fans by activating the switch. The control circuit can control whether the fans are enabled or disabled. The video game console, for example, may be a Microsoft Xbox 360^{™} console, or a Sony PlayStation^{™} 3 console.

In an exemplary embodiment, the cooling system may receive power from a power supply, use the power for its own operation, and pass the power on to a consumer electronics device. In another embodiment, the cooling system may have a pass-through design or architecture, in which it receives power from a consumer electronics device, uses the power for its own operation, and passes the power on to another external device.

In yet another embodiment of the present invention, a cooling system has two connectors. One connector couples the cooling system to a power supply port of a consumer electronics device. A second connector couples the cooling system to a power supply. The second connector may be of the same type as the power supply port of the consumer electronics device, such that the second connector replicates the power supply port. Thus, the power supply port is still available when the cooling system is connected.

In another embodiment of the present invention, a cooling system has a connector that couples the cooling system to a universal serial bus (USB) port of a consumer electronics device. The cooling system draws electrical power from the USB port and uses it for operation of one or more fans or other cooling elements. The cooling system may also include a second connector which is also a USB port, such that the second connector replicates the USB port of the consumer electronics device.

In another exemplary embodiment of the present invention, a cooling system also includes at least one charging unit. The charging units can be mounted to the sides of the housing. The charging units, for example, can charge a rechargeable battery for use with a controller for the video game console. The cooling system can include one or more charging units.

In another embodiment, a cooling system for a consumer electronics device having a power input port is provided, the cooling system including: a cooling element; a housing supporting the cooling element; a first connector configured to be coupled to the power input port of the consumer electronics device, the first connector having at least one electrical conductor for providing an electrical power to the consumer electronics device; and a second connector configured to be coupled to a power source and adapted to replicate the power input port of the consumer electronics device, the second connector having at least one electrical conductor for receiving power from the power source; wherein the second connector is electrically coupled to the first connector, and is electrically coupled to the cooling element to provide an electrical power to the cooling element.

In still another embodiment of the present invention, a cooling system for a consumer electronics device having a power input port is provided, the cooling system including: a cooling element; a housing supporting the cooling element; a first connector configured to be coupled to the power input port of the consumer electronics device, the first connector having at least one electrical conductor for providing alternating current (AC) power to the consumer electronics device; a second connector configured to be coupled to an AC power source, the second connector having at least one electrical conductor for receiving AC power from the power source; and an AC/DC converter electrically coupled to the cooling element and the second connector and adapted to receive AC power from the second connector and to provide DC power to the cooling element; wherein the first connector is electrically coupled to the second connector.

In yet another embodiment of the present invention, an accessory device for a consumer electronics device having a power input port is provided, the accessory device including: a housing containing at least one electrical component; a first connector configured to be coupled to the power input port of the consumer electronics device, the first connector having at least one electrical conductor for providing alternating current (AC) power to the consumer electronics device; a second connector configured to be coupled to an AC power source and adapted to replicate the power input port of the consumer electronics device, the second connector having at least one electrical conductor for receiving AC power from the power source; and an AC/DC converter supported by the housing and adapted to receive AC power from the second connector and to provide DC power to the electrical component; wherein the second connector is electrically coupled to the first connector.

In still another embodiment of the present invention, a cooling system for a consumer electronics device having a USB port is provided, the cooling system including: a cooling element; a housing supporting the cooling element; and a first connector configured to be coupled to the USB port of the consumer electronics device, the first connector having at least one electrical conductor for receiving an electrical power from the consumer electronics device; wherein the first connector is electrically coupled to the cooling element to provide at least a portion of the electrical power to the cooling element.

These and other aspects of the invention will be more readily comprehended in view of the discussion herein and the accompanying drawings.

Embodiments of the invention will now be described, by way of example only, with reference to the accompanying drawings, in which:
FIG. 1 is a schematic diagram of a consumer electronics system including a cooling system in an exemplary embodiment of the present invention;
FIG. 2 is a schematic block diagram of a cooling system in an exemplary embodiment of the present invention;
FIG. 3 is a schematic block diagram of a cooling system in another exemplary embodiment of the present invention;
FIG. 4 is a schematic block diagram of a cooling system in another exemplary embodiment of the present invention;
FIG. 5 is a cut-away perspective view of a consumer electronics system including a cooling system in an exemplary embodiment of the present invention;
FIG. 6 is a perspective view of a cooling system in an exemplary embodiment of the present invention;
FIG. 7 is a front view of the cooling system of FIG. 6;
FIG. 8 is a side view of the cooling system of FIG. 6;
FIG. 9 is a rear view of the cooling system of FIG. 6;
FIG. 10 is a schematic block diagram of a cooling system with charging units in an embodiment of the present invention;
FIG. 11 is a front view of a cooling system with charging units in an embodiment of the present invention;
FIG. 12 is a side view of the cooling system of FIG. 11;
FIG. 13a is a perspective view of a cooling system with a charging unit showing the battery removed in an embodiment of the present invention;
FIG. 13b is a perspective view of the cooling system of FIG. 13a showing the battery intact;
FIG. 14 is a perspective view of a cooling system in another embodiment of the present invention;
FIG. 15 is a perspective view of a cooling system in another embodiment of the present invention;
FIG. 16 is a perspective view of a cooling system in another embodiment of the present invention; and
FIG. 17 is a side view of the cooling system of FIG. 16.

Certain consumer electronics devices (e.g. video game consoles) have known heat dissipation problems. In particular, Microsoft's Xbox 360^{™} console is known to have a risk of overheating. Problems associated with overheating can include reduced system performance and instability that may result in software or hardware failure. Cooling systems in accordance with embodiments of the present invention can reduce the risk of overheating for the Xbox 360^{™}, other video game consoles, and/or other consumer electronics devices.

In an embodiment of the present invention, a cooling system for a consumer electronics device (CED), such as an Xbox 360, a PlayStation^{™} 3, or another video game console, provides high efficiency cooling for the internal elements of the CED. In an embodiment, one side of the cooling system connects to the power supply port of the CED, and the other side replicates that port so that the port is still available for use. The CED power supply may be connected to the replicated port, and the power may pass through the cooling system to the CED for the CED's operation. The cooling system taps into that power for its own use, in order to operate a cooling element such as one or more fans to cool the internal temperature of the CED. Such cooling reduces the operating temperature of the CED's internal circuitry, prolongs the CED's operating lifespan, and improves the CED's reliability and performance. No internal modification of the CED is required. Also, because the cooling system can tap into the power supply to the CED, the cooling system, in one embodiment, does not require its own external or internal power source, power cord, battery pack, or additional bulky alternating current (AC) adapter.

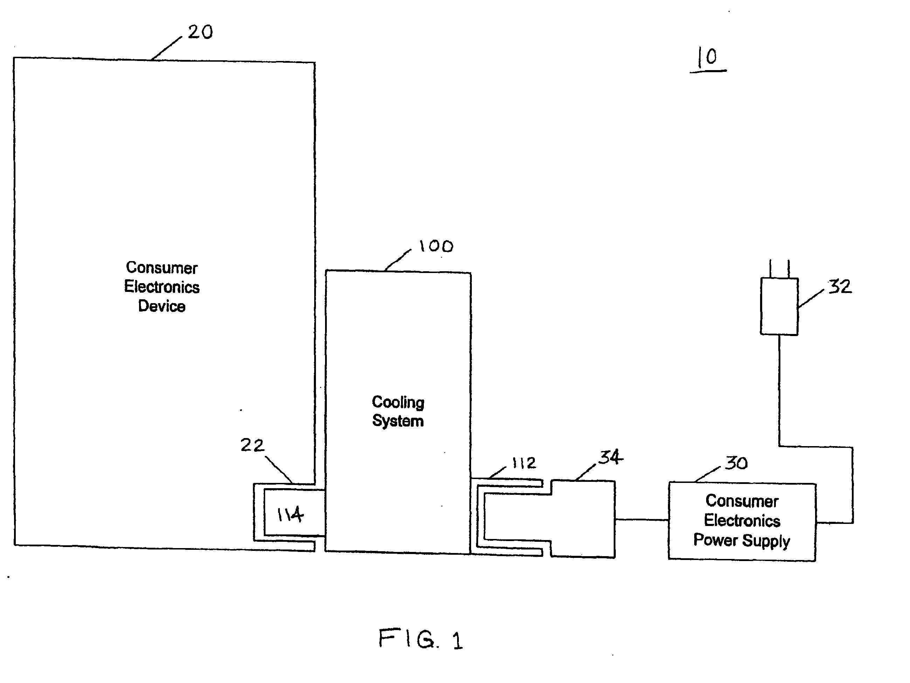

FIG. 1 is a schematic diagram of a consumer electronics system including a cooling system in an exemplary embodiment of the present invention. The consumer electronics system 10 includes a CED 20, a cooling system 100, and a consumer electronics power supply 30. In this embodiment, the CED is not a hand-held device and does not operate on its own internal power source, such as a battery pack, but instead takes power from the external consumer electronics power supply 30. In other embodiments, the CED may be a hand-held device and/or may have an internal (e.g., rechargeable) power source such as a battery pack. The CED 20 includes a female connector 22. The cooling system 100 includes a male connector 114 and a female connector 112. The CED power supply 30 includes a male connector 34 and a plug 32. The power supply 30 is connected to the male connector 34 and the plug 32 via respective electrical cables or wires. In other embodiments, the connector types (male or female) can be reversed or arranged differently, or the connections may be made using any other suitable methods known to those skilled in the art.

In operation, the male connector 114 of the cooling system can be connected to the female connector 22 of the CED 20. The male connector 34 of the power supply can be connected to the female connector 112 of the cooling system. The plug 32 can be connected to an alternating current receptacle, such as a wall outlet (not shown). The connections between the power supply, the cooling system, and the CED can be made in any suitable manner known to those skilled in the art (i.e., not limited to male and female connectors). In one exemplary embodiment, the CED 20 is an Xbox 360™. In other embodiments, the cooling system can be configured to interact with other video game consoles or other CEDs, e.g., CEDs having heat dissipation problems.

In an exemplary embodiment of the invention, the female connector 112 of the cooling system 100 is of the same type as the female connector 22 of the CED 20. Thus, when the cooling system 100 is connected to the CED 20, the female connector 112 replicates the connector 22. The cooling system thus replicates the port that it is connected to in the CED. The connector 22 in the CED is still available for use through the female connector 112 of the cooling system 100. With this design, the CED power supply 30 can be connected to the female connector 112 in the same way that it would be connected to the connector 22 if the cooling system were not present. Power from the power supply 30 passes through the cooling system 100 and through the connectors 114 and 22 into the CED for the CED's operation. Alternatively, any other peripheral or accessory device that can connect to the connector 22 of the CED 20 can be connected to the connector 112 of the cooling system 100, because the connector 112 preserves the availability of the connector 22.

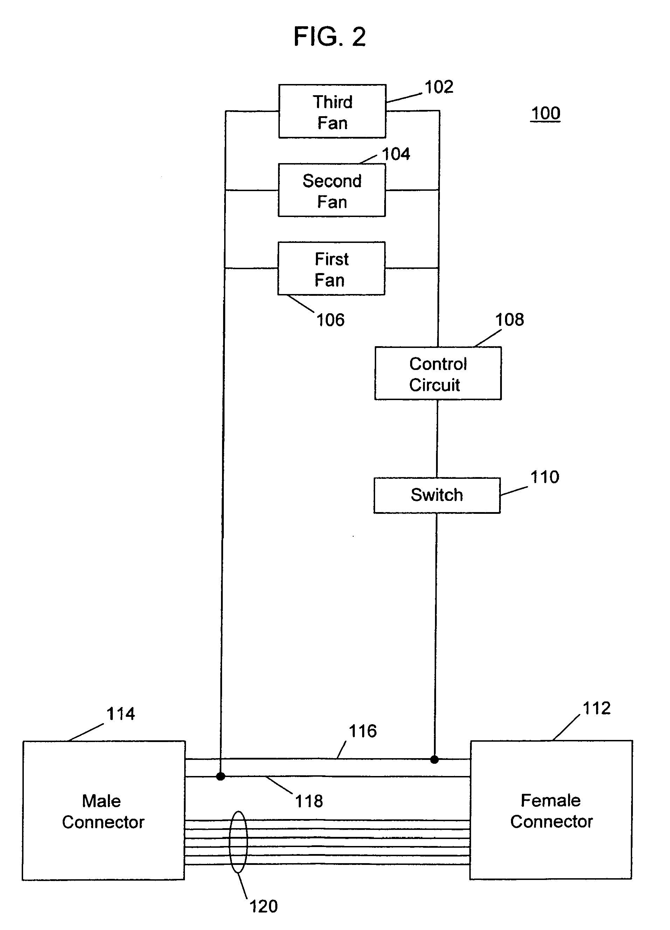

FIG. 2 is a schematic block diagram of a cooling system in an exemplary embodiment of the present invention. The cooling system 100 includes a male connector 114, a female connector 112, a first fan 106, a second fan 104, a third fan 102, a control circuit 108, a switch 110, a power conductor 116, a ground conductor 118, and six pass-through conductors 120. In other embodiments, the number of pass-through conductors may be more than or less than six. The male connector 114 is connected to the pass-through conductors 120, the power conductor 116, and the ground conductor 118. The female connector 112 is also connected to the pass-through conductors 120, the power conductor 116, and the ground conductor 118. The power conductor 116 is connected to the switch 110. The switch 110 is connected to the control circuit 108. The control circuit is connected to the first fan 106, the second fan 104, and the third fan 102. The ground conductor is also connected to the first fan 106, the second fan 104, and the third fan 102.
In the embodiment shown in FIG. 2, the cooling system 100 takes in and passes through direct current (DC) power. The CED power supply 30 (shown in FIG. 1) takes alternating current (AC) power from the plug 32, such as a wall plug, and converts the AC power into DC form. The power supply 30 then passes this DC power to the female connector 112 of the cooling system 100. The cooling system receives this DC power, uses it for operation of the fans 102, 104, and 106, and passes the DC power to the CED through the pass-through conductors 120 and the male connector 114.

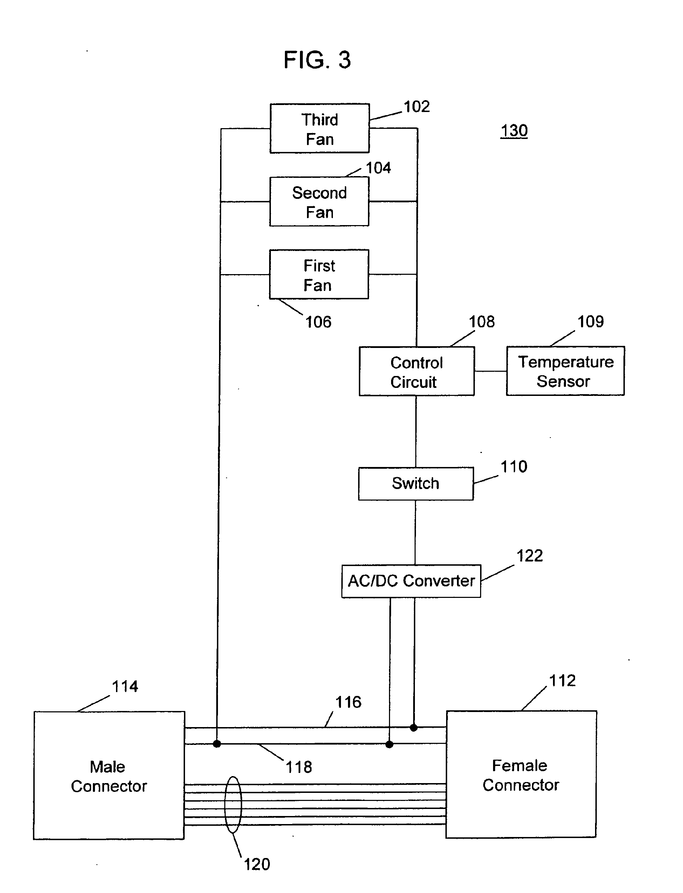

In the embodiment shown in FIG. 3, a cooling system 130 takes in and passes through AC power instead of DC power. The cooling system 130 can be used with a CED that accepts AC power. The cooling system 130 may be used to replace the cooling system 100 of FIG. 1. The power supply 30 may take AC power directly from a plug 32, such as a wall plug, and pass it to the cooling system through the connectors 34 and 112. The cooling system 130 then passes the AC power to the CED through the pass-through conductors 120 and the connectors 114 and 22. In this embodiment, the cooling system includes its own internal AC/DC converter 122, which includes a transformer to convert AC power to DC power for operation of the fans 102, 104, and 106. The AC/DC converter 122 receives AC power from the connector 114, converts it into DC power, and provides this DC power to the fans 102, 104, and 106. The AC/DC converter 122 is connected to the power conductor 116, the ground conductor 118, and the switch 110.

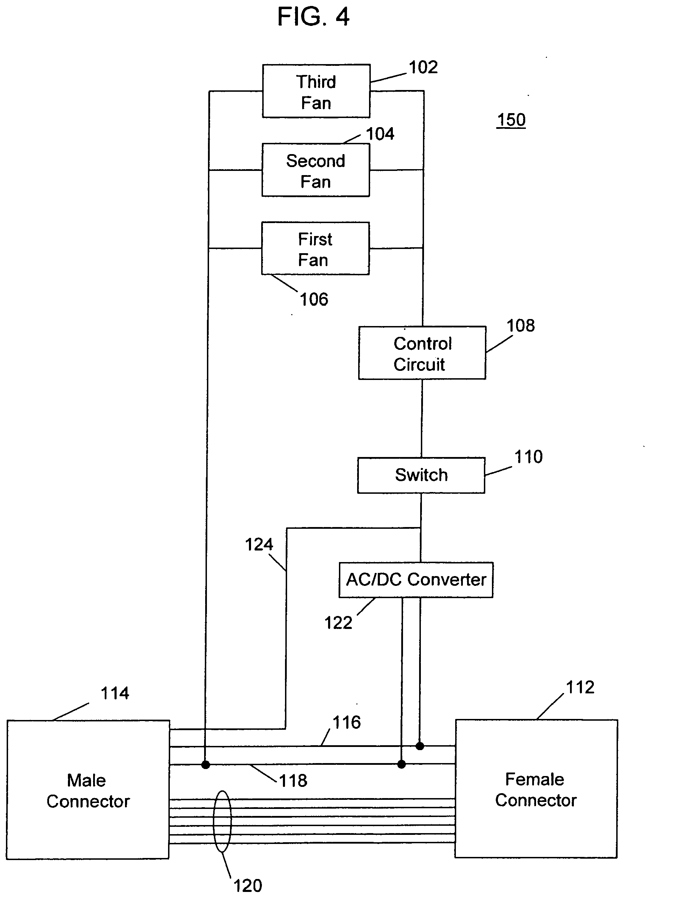

In FIG. 4, showing another embodiment of the invention, a cooling system 150 receives AC power at the female connector 112, and passes on both AC and DC power through the male connector 114. The cooling system 150 may be used to replace the cooling system 100 of FIG. 1. The pass-through conductors 120 pass AC power directly from the female connector 112 to the male connector 114. The AC/DC converter 122 includes a transformer to convert AC power to DC power. The AC/DC converter takes the AC power from the female connector 112, converts it to DC power, and passes this power to the switch 110, control circuit 108, and fans 102, 104, and 106. The AC/DC converter is connected to the power conductor 116, the ground conductor 118, and the switch 110. A second pass-through conductor 124 is connected between the male connector 114 and the DC output of the AC/DC converter 122. The second pass-through conductor 124 takes the DC power from the AC/DC converter and passes it to the male connector 114. Thus, the male connector 114 can supply both AC and DC power.

In operation, the cooling system 100 (or other embodiments such as cooling systems 130, 150, 200, 300, 350, 400) can be activated when the male connector 114 is connected to the CED 20 and the female connector 112 is connected to the CED power supply 30 (see FIG. 1). A direct current (DC) voltage can be applied to the power conductor 116. In an exemplary embodiment, the voltage can be 12 volts. In other embodiments, the voltage can be more than or less than 12 volts. The ground conductor can also be enabled when the cooling system is connected to the CED and the power supply.

The switch 110 can be any type of switch known to those skilled in the art, and can be manually operated by the user. When the switch 110 is activated, power is supplied to the fans 102, 104, and 106. When the switch is deactivated, no power is delivered to the fans. When the switch is activated, the fans may be turned off and on by the control circuit 108 (described below). The switch allows the user to operate the CED while the cooling system is deactivated. The cooling system 100 does not have to be disconnected and/or removed from the CED in order to operate the CED without the cooling system. The pass-through conductors 120 can provide power to the CED even when the switch 110 is deactivated and the fans are turned off. Thus, the cooling system 100 may remain in place, connected to the CED, even when the user does not wish to operate the cooling system. In other words, the cooling system does not alter the operation of the CED. In other embodiments, the switch 110 maybe absent, and/or the cooling system may be powered up together with the CED, and may be powered off when the CED is powered off.

The control circuit 108 can activate all fans for maximum cooling, or disable the fans periodically to save energy or reduce fan noise. In one embodiment, the control circuit can enable each of the fans independently. The control circuit 108 may be used to control or adjust the speed of one or more fans, and may include a switch for controlling the speed of fans individually, together, sequentially and/or in any other manner suitable for desired cooling purposes. In another embodiment, the control circuit 108 is not present, and the fans are activated when the CED is activated and are turned off when the CED is turned off. In this embodiment, the fans remain enabled while a voltage remains on the power conductor. If a switch is present, the fans may be activated when the switch is activated, and may be turned off when the switch is deactivated.

In other embodiments, the control circuit 108 may have a temperature sensor 109 (shown in FIG. 3). The control circuit 108 may receive an input from the temperature sensor 109, such that it can automatically shut off or on and/or vary the speeds of one or more fans depending on the temperature measured. Alternatively, the control circuit 108 may have a timer that controls when the fans are turned on or off or adjusted, or the control circuit 108 may have both a timer and a temperature sensor. The timer may operate as a backup for the temperature sensor, or vice versa, to make sure that the CED does not overheat. The temperature sensor 109 is shown as part of the cooling system 130 in FIG. 3, but it may also be used in other embodiments of the cooling system. Alternatively, the temperature sensor may be absent.

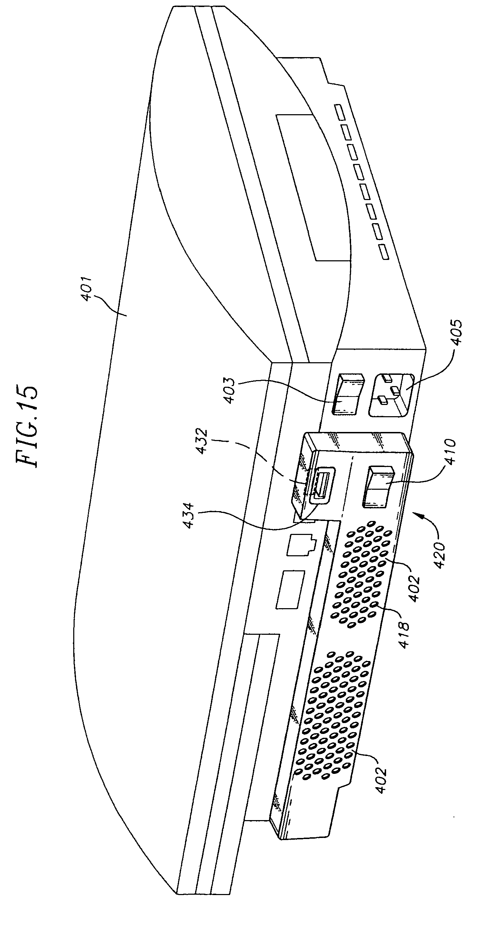

As depicted in FIGs. 2-4, the cooling system 100 (or other embodiments such as cooling systems 130, 150, 200, 300, 350, 400, 420) has a pass-through architecture, in which the fans 102, 104, 106 and the control circuit 108 are supplied with power from the CED power supply, which receives power from a wall outlet through an AC adapter, for example, without requiring an internal or other external power source. Also, in this embodiment, the cooling system 100 takes power directly from the power supply of the CED rather than taking power through a Universal Serial Bus (USB) port, for example. In other embodiments, the cooling system may take power from a USB port (see FIGs. 15, 16, 17 described below), and/or may have an internal power source (e.g., rechargeable battery) and/or may receive power from an external power source, instead of or in addition to the power supplied from the CED.

Also, it can be seen in FIGs. 1 through 4, the female connector 112 and the male connector 114 are arranged as pass-through plugs. In other embodiments, instead of using self contained male and female plugs, a cable lead can be used at one end or both ends to pass through power. In an exemplary embodiment, the male and female connectors have eight pins. In other embodiments, the male and/or female connector may have more than eight pins or less than eight pins.

While three fans 102, 104, and 106 are shown and described in reference to FIGs. 2, 3 and 4 (and other figures below), the present invention is not limited thereto, and the number and size of fans may be different in other embodiments depending on the type of CED, and the purpose of cooling. For example, the size of the fans can be larger or smaller, and less than or more than three fans can be used. In one embodiment, the fans are "LYF Sleeve" 12V DC fans. In various other embodiments, the fans can be any suitable fans that are known to those skilled in the art. The fans may be variable in speed, or may operate at only one speed. In the embodiment shown in FIG. 3, three fans are used and are arranged vertically. In other embodiments, the fans could be arranged horizontally, or could be in any other suitable arrangement. Additionally, the fans may all be the same size or could be various sizes, and they can operate at the same or different speeds. The number, size, and shape of the rotors in the fans may also vary. In still another embodiment, other suitable cooling elements known to those skilled in the art could be used in place of fans.

In one embodiment, the fans draw air out of the CED and expel the air into the surrounding environment. By drawing heated air out of the CED, the fans increase the circulation of air inside the CED housing, which increases cooling. The hot air that is drawn out of the CED by the fans is replaced by cooler air from the surrounding environment that enters the CED through cracks, vents, crevices, and/or other openings in the CED's external housing. In another embodiment, the fans may blow air into the CED from the external environment. This air will then circulate through the CED and exhaust at cracks, vents, crevices, and/or other openings in the CED's external housing. This circulation helps to force out the hot internal air inside the CED housing, as the fans blow cooler air in.

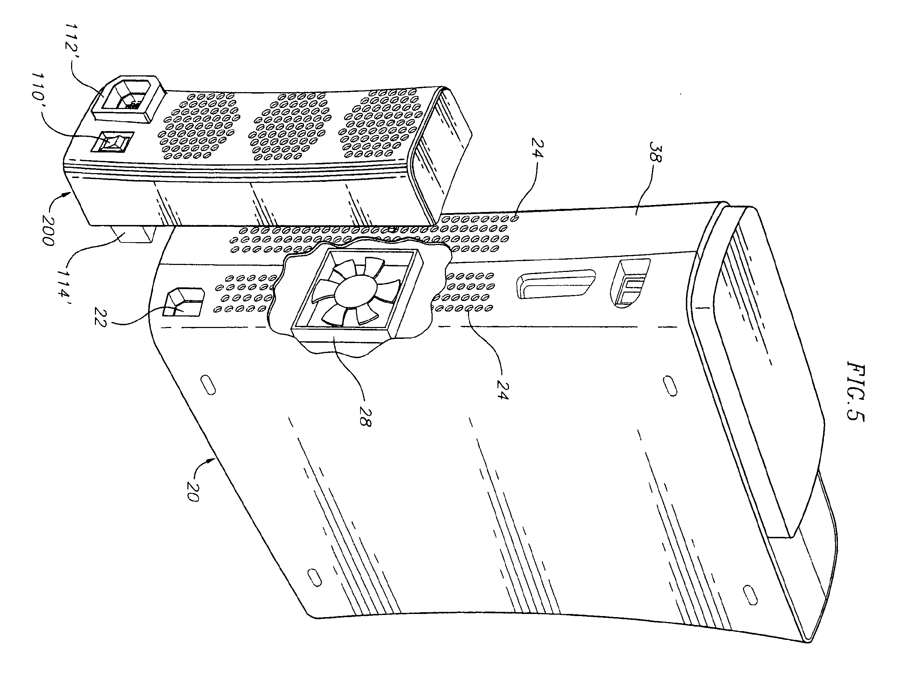

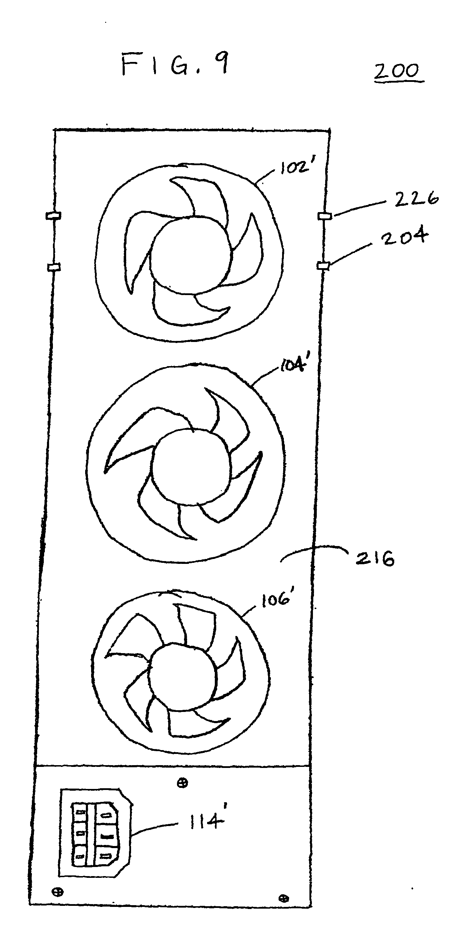

In another embodiment, shown in FIG. 5, a cooling system 200 is used with the CED 20 with external vents 24 in its external housing 38. The external vents 24 generally allow air to circulate into and out of the CED housing 38. When the cooling system 200 (or other embodiments such as cooling systems 100, 130, 150, 300, 350, 400, 420, 440) is employed, it may be aligned with these vents 24, as shown in FIG. 5, or other corresponding vents. This alignment facilitates cooling of the CED by allowing the fans 102', 104', and 106' (shown in FIG. 9), or other cooling elements inside the cooling system 200, to extract hot air through the vents 24 from inside the CED housing 38 and/or introduce cool air through the vents 24 into the CED housing 38. In other embodiments, the cooling system 200 may be aligned with other types of openings in the CED external housing, such as holes, cracks, or slits.

In another embodiment, the CED 20 may have its own internal fan 28, shown in FIG. 5. The internal fan 28 may circulate air through the internal circuitry of the CED and exhaust air through the CED's external vents 24. The cooling system 200 may work with the internal fan of the CED to improve air circulation. The CED's internal fan 28 may blow hot air toward the CED's external vents 24, and then the fans 102', 104', and 106' may draw that hot air out through those vents 24 and expel the hot air into the surrounding environment. Alternatively, or in addition, the fans 102', 104', and 106' in the cooling system may blow cooler air into the CED toward the CED's internal fan 28, so that the CED's internal fan 28 can then circulate that cooler air throughout the CED 20.

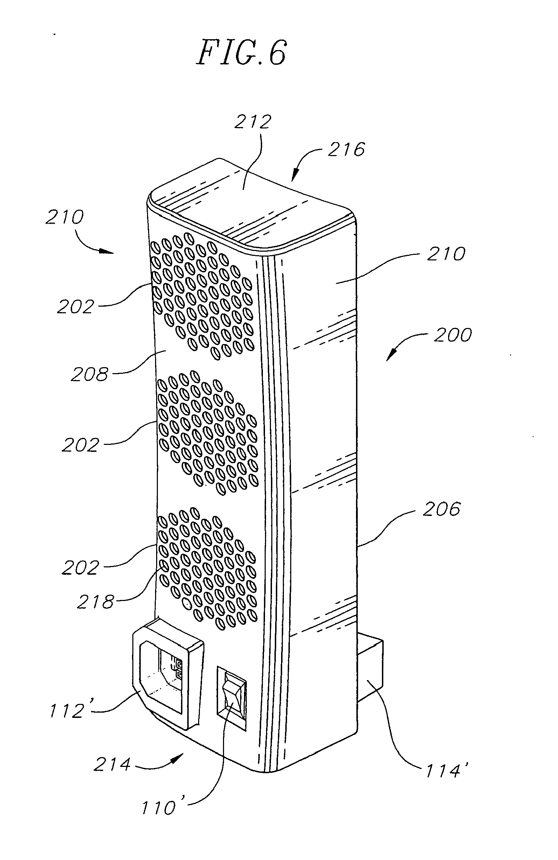

FIG. 6 is a perspective view of the cooling system 200 in an exemplary embodiment of the present invention. The cooling system 200 includes a housing 206, a switch 110', a female connector 112', a male connector 114' (shown in FIG. 9), three fans (shown in FIG. 9), and three fan openings or vents 202. The housing 206 includes a front panel 208, two side panels 210, a bottom panel 214, a top panel 212, and an open back 216 (shown in FIG. 9). The switch 110' and the female connector 112' can be disposed on the lower portion of the front panel 208. The fan openings 202 can be disposed on the upper portion of the front panel 208. The fans can be mounted behind the fan openings 202.

In operation, the fan openings can enable heated air to pass through the housing and away from the CED. The fans can extract hot air from within the CED and expel the hot air through the fan openings. In another embodiment, the fan openings can enable cooler air to pass through the fan openings and into the CED, as the fans draw cooler air from the surrounding environment and blow the air into the CED. In one embodiment, the front panel of the housing can be approximately 19.5 cm in height and approximately 6.0 cm in width. The side panels can be approximately 4.0 cm in width. The housing 206 can be made of a rigid plastic material, or other suitable materials known to those skilled in the art.

The housing 206 may be shaped or contoured to match the shape or contour of the CED. The housing 206 can thus fit closely or snugly against the CED. A snug fit improves cooling by preventing leakage of air around the edges or sides of the housing. A snug fit also improves the aesthetic appearance of the cooling system, and minimizes the extra space occupied by the cooling system. Thus, the CED may still fit inside a cabinet, entertainment center, shelving, or other container when the cooling system is employed. The housing 206 may also be shaped to cover or align with the CED's external vents 24 (shown in FIG. 5 and discussed above).

In the embodiment shown in FIG. 6, the fan openings 202 are arranged vertically on the front panel 208. Each fan opening 202 includes several smaller holes 218 clustered together. These small holes 218 allow air to enter and/or exit the cooling system, and also provide protection from foreign objects entering the cooling system and disrupting the operation of the fans. Larger openings could allow foreign objects to enter the housing 206. In this embodiment, each fan opening 202 is approximately the same size as the fan behind it. The opening 202 thus prevents the front panel 208 from blocking air flow from or to the fan. In other embodiments, the arrangement, size, and spacing of the small holes 218 and the fan openings 202 may vary. For example, the small holes 218 may be larger or smaller, and may vary in shape and spacing. The fan openings 202 may also be spaced differently according to the arrangement and placement of the fans, and the contour and shape of the housing 206.

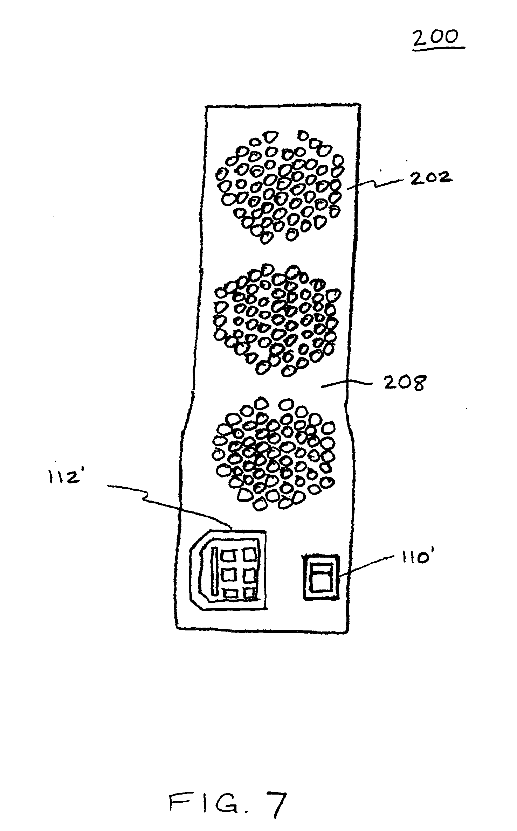

FIG. 7 is a front view of the cooling system of FIG. 6. The fan openings 202 are visible on the front panel 208. The switch 110' and female connector 112' are disposed on the lower portion of the front panel 208.

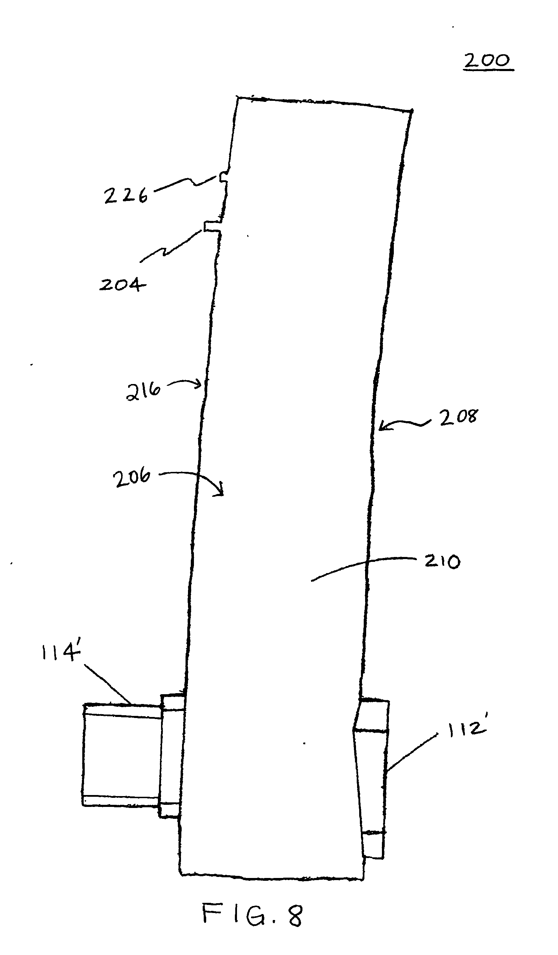

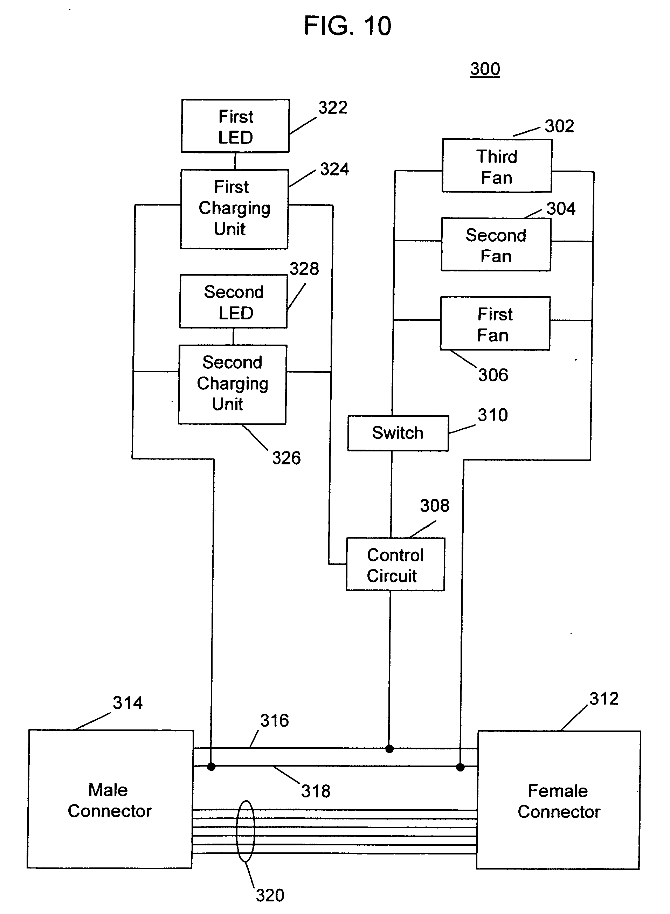

FIG. 8 is a side view of the cooling system of FIG. 6. The cooling system further includes attachment protrusions 204 and 226. In operation, the cooling system can be snapped onto the CED (see FIGs. 1, 10). The combination of the attachment protrusions and the male connector can retain the cooling system such that it remains engaged or attached to the CED. In an exemplary embodiment, the cooling system can be shaped such that it fits closely with the back of the CED (see FIGs. 1, 10). In the embodiment shown in FIG. 8, both attachment protrusions 226 and 204 are provided on each of the side panels 210. The attachment protrusions may be adapted to fit to a particular CED, based on the construction of the CED's external housing. The attachment protrusions may fit into a crack or groove in the CED's external housing, or may fit around side panels of the CED's external housing, or may engage the CED in any other suitable fashion. The protrusion 204 may be larger than the protrusion 226, or vice versa, or they may be the same size. In other embodiments, each side panel 110 may have more than or less than two attachment protrusions, or one or both side panels 110 may not have any attachment protrusions. The attachment protrusions provide additional support to improve the snug fit of the cooling system against the CED. However, the attachment protrusions are optional, and the male connector 114 may be used to retain the cooling system against the CED. Alternatively, the cooling system may rest near or next to the CED without requiring the attachment protrusions or the male connector to attach or retain the cooling system against the CED.

As shown in FIG. 8, the cooling system 200 (or other embodiments such as cooling systems 100, 130, 150, 300, 350) may have a curved contour. The housing 206 forms a curved shape on the back side 216, and on the front side 208. This contouring may match the contouring of the CED for which the cooling system 200 is used. In other embodiments, the housing 206 may be contoured in other shapes and forms, in order to fit other CEDs.

FIG. 9 is a rear view of the cooling system of FIG. 6. The cooling system 200 can include a first fan 106', a second fan 104', a third fan 102', a male connector 114', an open back 216, and attachment protrusions 204 and 226.

FIG. 10 is a schematic diagram of a cooling system with charging units in an embodiment of the present invention. The cooling system 300 with charging units includes a male connector 314, a female connector 312, a first fan 306, a second fan 304, a third fan 302, a switch 310, a control circuit 308, a first light emitting diode (LED) 322, a first charging unit 324, a second LED 328, a second charging unit 326, a power conductor 316, a ground conductor 318, and pass-through conductors 320.

The pass-through conductors 320 are connected to the male connector 314 and to the female connector 312. The power conductor 316 is connected to the male connector 314 and the female connector 312 and the control circuit 308. The ground conductor 316 is connected to the male connector 314 and the female connector 312.

The control circuit 308 is connected to the switch 310. The switch 310 is connected to the first fan 306, the second fan 304, and the third fan 302. The ground conductor 318 is connected to the first fan 306, the second fan 304, and the third fan 302. The control circuit 308 is connected to the first charging unit 324 and the second charging unit 326. The first charging unit 324 is connected to the first LED 322. The second charging unit 326 is connected to the second LED 328. The ground conductor 318 is connected to the first charging unit 324 and the second charging unit 326.

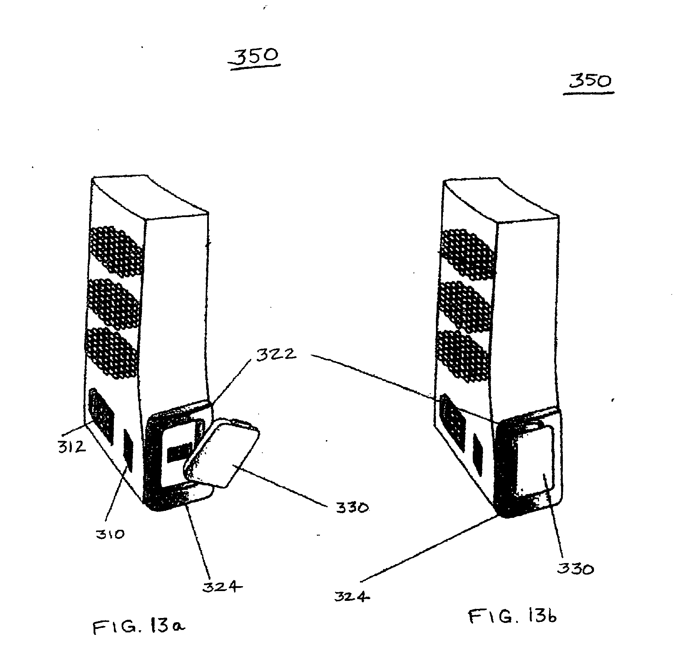

The control circuit 308 can enable the charging units 324 and 326. In other embodiments, the control circuit is not present, and the charging units are activated when the CED is powered on and are deactivated when the CED is powered off. The charging units may also be controlled by a second switch such that the user can control whether power is or is not provided to the charging units. In still other embodiments, the charging units may each include their own control circuits that provide power when the device to be charged (see FIGs. 13a and 13b) is connected to the charging unit, and may stop providing power when that device is fully charged or removed.

The charging units can charge rechargeable batteries, for example, in one embodiment. In an exemplary embodiment, the charging units charge one or two rechargeable batteries for a wireless Xbox 360 controller, such as the "Xbox 360 Rechargeable Battery Pack." In other embodiments, the charging units may provide power to other accessory devices, such as accessories for the Xbox 360, or may charge batteries for other accessory devices, such as other types of controllers or peripheral devices for the Xbox 360. The two charging units may charge the same type of device, or each may charge a different device.

In the embodiment shown in FIG. 10, each charging unit is coupled to an LED. The first LED 322 can indicate whether the battery or other device placed in the first charging unit is currently being charged. The second LED 328 can indicate whether the battery or other device placed in the second charging unit is currently being charged. The charging units and/or the control circuit can determine when the batteries or other devices are fully charged. In response, the charging units can stop further charging of the batteries and indicate via the LEDs that the batteries or other devices have been fully charged.

In several embodiments, only one charging unit is used. With only one charging unit mounted on the cooling system, the entire CED can lie on its side without resting on a charging unit. In one embodiment, the charging units are removable from the cooling system. In this way, the CED can lie on its side without resting on a charging unit if desired by the user. Thus, the CED can rest horizontally or vertically, even when the cooling system is attached. In several embodiments, the charging units are not removable from the cooling system.

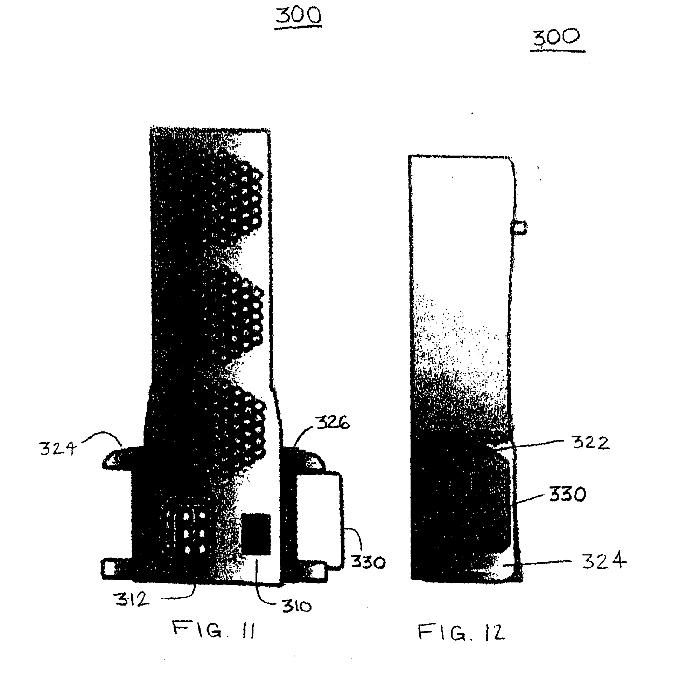

FIG. 11 is a front view of a cooling system with charging units in an embodiment of the present invention. This embodiment of the cooling system can have many of the same physical characteristics of the cooling system of FIG. 6 while also having one or more charging units 324 and 326. The cooling system with charging units can also include a rechargeable battery 330. In FIG. 11, the rechargeable battery 330 is attached to charging unit 326, while charging unit 324 is empty. The charging units 324 and 326 may operate independently, such that one charges a battery or other rechargeable device while the other is empty. As can be seen in FIG. 11, the charging units 324 and 326, when attached to the cooling system, may prevent the cooling system 300 from lying flat on its side. When the cooling system 300 is used with a CED, it may be desirable to arrange the CED and cooling system horizontally, on their side panels, in order to place them into an entertainment stand or cabinet or other suitable shelving. In one embodiment, the charging units 324 and 326 are removable from the cooling system 300. Thus, one or both charging units can be removed when not in use so that the cooling system and CED can lie flat horizontally. In other embodiments, only one charging unit is removable, enabling the cooling system and CED to lie flat on one side. For example, in FIG. 11, the charging unit 324 may be removably mounted to the cooling system 300 so that it can be removed when not in use. In still other embodiments, the charging units are not removable.

FIG. 12 is a side view of the cooling system of FIG. 11. The charging unit 324 is shown with the rechargeable battery 330 in place. The charging unit 324 includes an LED 322 which can indicate whether the battery 330 or other device placed in the first charging unit is currently being charged, and/or when it is finished charging.

FIG. 13a is a perspective view of a cooling system 350 with a charging unit 324 in an embodiment of the present invention. In this embodiment, the cooling system 350 includes only one charging unit 324. The charging unit 324 charges a rechargeable battery 330, which is removed from the charging unit in FIG. 13a. The charging unit 324 also includes an LED 322 which can indicate the charging status of the battery 330.

FIG. 13b is a perspective view of the cooling system 350 of FIG. 13a, showing the battery 330 intact in an embodiment of the present invention. The LED 322 may visually indicate that the battery 330 is being charged and/or that it is finished charging and/or that it needs charging.

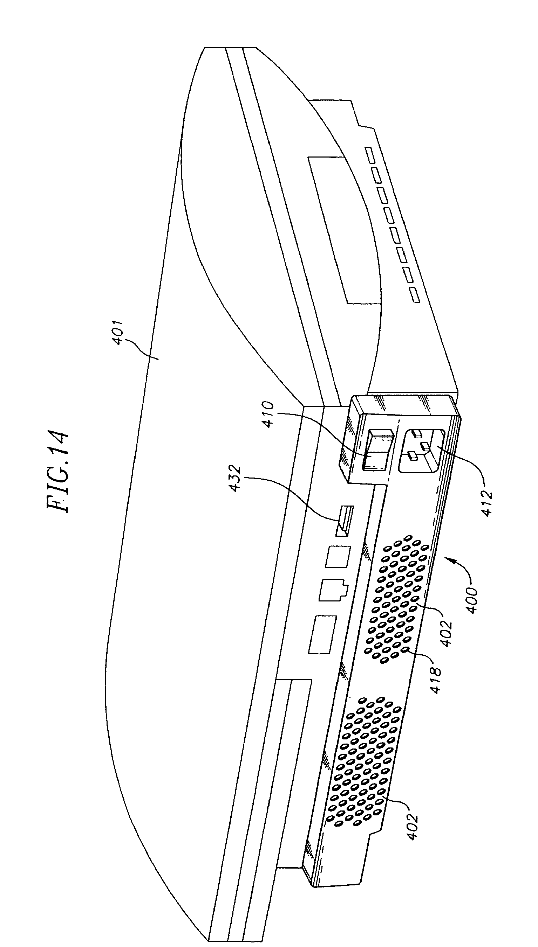

The inventive features (e.g., pass-through power, port replication, control circuit, charging units, AC/DC converter, etc.) and principles of the cooling systems depicted in the previous figures apply to the cooling systems 400, 420, 440 also, shown in FIGs. 14-17 below. FIG. 14 is a perspective view of a cooling system 400 in another embodiment of the present invention. The cooling system 400 includes a swiTch 410, a female connector 412, and fan openings 402. The cooling system 400 is connected to a CED 401. The CED 401 may be, for example, a PlayStation 3 (PS3) video game console. In this embodiment, the cooling system 400 may have six fans, with three fans behind each of the openings 402. The fan openings 402 include a plurality of smaller holes 418. In FIG. 14, the fan opening 402 on the left has six rows of smaller holes 418, while the fan opening 402 on the right has five rows of smaller holes 418. The spacing, arrangement, size, and number of fan openings 402 and smaller holes 418 may vary according to different embodiments of the invention and different CEDs.

In FIG. 14, the cooling system 400 is mounted horizontally on the CED 401. In other embodiments, such as the cooling system 200 shown in FIG. 5, the cooling system is mounted vertically on the CED. The horizontal or vertical mounting of the cooling system may depend on the configuration, size, and shape of the CED. FIG. 14 also shows a USB port 432 on the CED 401. In other embodiments, described below, the cooling system may attach to this USB port 432.

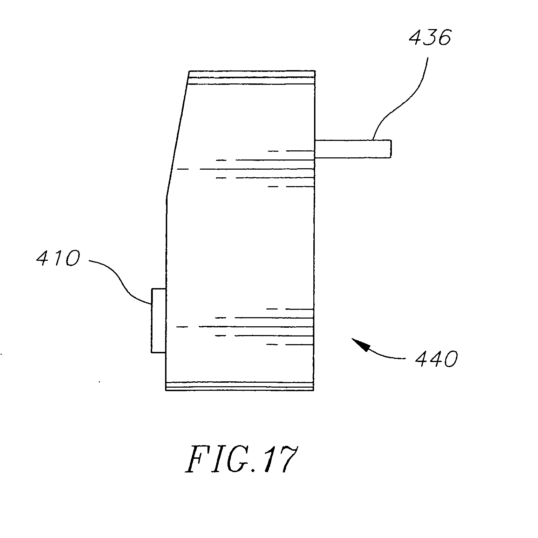

FIG. 15 is a perspective view of a cooling system 420 in another embodiment of the present invention. The cooling system 420 includes a USB plug 436 (shown in FIG. 17) that connects to a USB port 432 of a CED 401. In this embodiment, the cooling system 420 takes power from the USB port 432 instead of from a CED power supply. Power flows from the CED through the USB port 432 and USB plug 436 into the cooling system 420. The cooling system 420 shown in FIG. 15 also includes a pass-through USB port 434 on the opposite side of the cooling system from the USB plug 436. The pass-through USB port 434 is of the same type as the USB port 432 of the CED 401. Thus, when the cooling system 420 is connected to the CED 401, the pass-through USB port 434 replicates the CED USB port 432. The CED USB port 432 is still available for use through the pass-through USB port 434 of the cooling system 420. With this design, a peripheral or accessory device that can connect to the CED USB port 432 can be connected to the pass-through USB port 434 of the cooling system 420, which preserves the availability of the CED USB port 432.

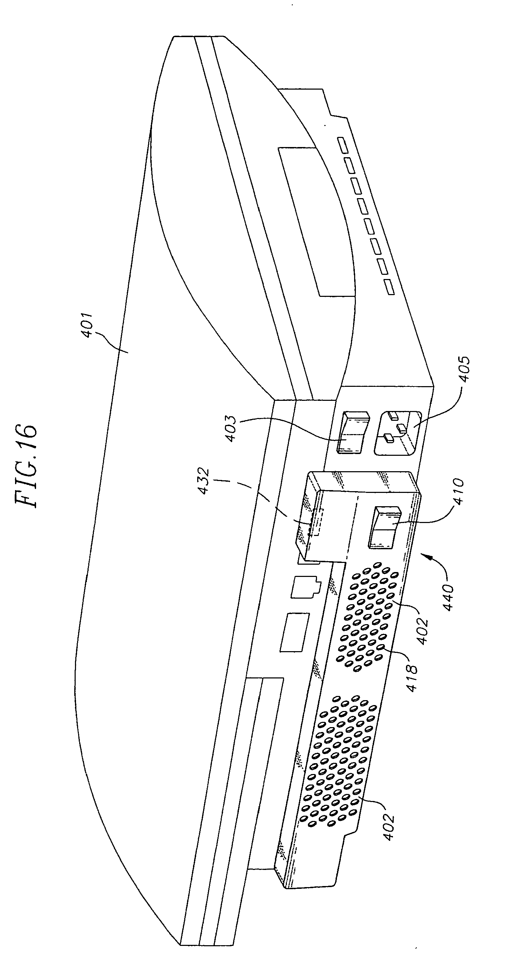

FIG. 16 is a perspective view of a cooling system 440 in another embodiment of the present invention. In this embodiment, the pass-through USB port 434 shown in FIG. 15 may be absent. The cooling system may draw power from the CED 401 through the CED USB port 432 and USB plug 436 (shown in FIG. 17) without passing on the availability of the CED USB port 432. The cooling system 440 draws power from the CED through the CED USB port 432 and uses the power for the cooling system's own operation, without passing the power on to another external or peripheral device.

FIG. 17 is a side view of the cooling system 440, showing the USB plug 436. The USB plug 436 may connect to any standard USB port, such as the CED USB port 432 shown in FIGs. 15 and 16.

It will be appreciated by those with ordinary skill in the art that the invention can be embodied in other specific forms without departing from the spirit or essential character thereof. The embodiments described above should be considered to be illustrative and not restrictive. The scope of the present invention is defined by the appended claims and their equivalents.

## Claims

1. A cooling system for a consumer electronics device having a power input port, the cooling system comprising:
a cooling element;
a housing supporting the cooling element;
a first connector configured to be coupled to the power input port of the consumer electronics device, the first connector comprising at least one electrical conductor for providing an electrical power to the consumer electronics device; and
a second connector configured to be coupled to a power source and adapted to replicate the power input port of the consumer electronics device, the second connector comprising at least one electrical conductor for receiving power from the power source;
wherein the second connector is electrically coupled to the first connector, and is electrically coupled to the cooling element to provide an electrical power to the cooling element.

2. The cooling system of claim 1, wherein the cooling element comprises at least one fan.

3. The cooling system of claim 1 or 2, wherein the consumer electronics device comprises a video game console.

4. The cooling system of any preceding claim, further comprising a switch electrically coupled to the cooling element and adapted to interrupt the electrical power to the cooling element.

5. The cooling system of any preceding claim, further comprising a control circuit electrically coupled to the cooling element and adapted to control the electrical power provided to the cooling element.

6. The cooling system of any preceding claim, further comprising a temperature sensor electrically coupled to the control circuit to provide a temperature input to the control circuit.

7. The cooling system of any preceding claim, further comprising a charging unit mounted on the housing and electrically coupled to the second connector to receive at least a portion of the power from the power source.

8. The cooling system of claim 7, wherein the charging unit is a battery recharger adapted to recharge batteries related to the consumer electronics device.

9. The cooling system of claim 7 or 8, wherein the charging unit is removably mounted on the housing.

10. The cooling system of claim 7, 8 or 9, further comprising a visual indicator electrically coupled to the charging unit to indicate a status of the charging unit.

11. The cooling system of any preceding claim, wherein the housing further comprises an attachment protrusion adapted to retain the cooling system on the consumer electronics device.

12. The cooling system of any preceding claim, wherein the housing is shaped to fit closely to the consumer electronics device.

13. The cooling system of any preceding claim, wherein the first and second connectors are integral to the housing.

14. A cooling system for a consumer electronics device having a power input port, the cooling system comprising:
a cooling element;
a housing supporting the cooling element;
a first connector configured to be coupled to the power input port of the consumer electronics device, the first connector comprising at least one electrical conductor for providing alternating current (AC) power to the consumer electronics device;
a second connector configured to be coupled to an AC power source, the second connector comprising at least one electrical conductor for receiving AC power from the power source; and
an AC/DC converter electrically coupled to the cooling element and the second connector and adapted to receive AC power from the second connector and to provide DC power to the cooling element;
wherein the first connector is electrically coupled to the second connector.

15. The cooling system of claim 14, wherein the second connector is adapted to replicate the power input port of the consumer electronics device.

16. The cooling system of claim 14 or 15, wherein the first connector is electrically coupled to the AC/DC converter and is adapted to provide DC power to the consumer electronics device.

17. An accessory device for a consumer electronics device having a power input port, the accessory device comprising:
a housing containing at least one electrical component;
a first connector configured to be coupled to the power input port of the consumer electronics device, the first connector comprising at least one electrical conductor for providing alternating current (AC) power to the consumer electronics device;
a second connector configured to be coupled to an AC power source and adapted to replicate the power input port of the consumer electronics device, the second connector comprising at least one electrical conductor for receiving AC power from the power source; and
an AC/DC converter supported by the housing and adapted to receive AC power from the second connector and to provide DC power to the electrical component;
wherein the second connector is electrically coupled to the first connector.

18. The accessory device of claim 17, wherein the electrical component comprises a fan.

19. The accessory device of claim 17 or 18, wherein the electrical component comprises a charging unit.

20. The accessory device of claim 17, 18 or 19, wherein the first connector is electrically coupled to the AC/DC converter and is adapted to provide DC power to the consumer electronics device.

21. A cooling system for a consumer electronics device having a USB port, the cooling system comprising:
a cooling element;
a housing supporting the cooling element; and
a first connector configured to be coupled to the USB port of the consumer electronics device, the first connector comprising at least one electrical conductor for receiving an electrical power from the consumer electronics device;
wherein the first connector is electrically coupled to the cooling element to provide at least a portion of the electrical power to the cooling element.

22. The cooling system of claim 21, further comprising a second connector configured to be coupled to a USB plug and adapted to replicate the USB port of the consumer electronics device, wherein the second connector is electrically coupled to the first connector.

23. The cooling system of claim 21 or 22, wherein the cooling element comprises at least one fan.
